# EUROPEAN PATENT APPLICATION

(11) **EP 3 637 180 A1**
(43) Date of publication of application: **15.04.2020**
(21) Application number: 18199783.4
(22) Date of filing: 11.10.2018
(51) Int. Cl.: G02F 1/13357, G02B 6/00, G02F 1/1333, G02F 1/1335, C08K 11/00, C09K 11/02, H01L 33/04

(54) **POLYMER RAIL WITH MOISTURE AND OXYGEN STABLE QUANTUM DOTS**

(71) Applicant: SABIC Global Technologies B.V., 4612 PX Bergen op Zoom (NL)
(72) Inventor: CHEN, Zhe, Shanghai, 201319 (CN); YANG, Yang, Shanghai, 201319 (CN); QIAN, Shengying, Shanghai, 201319 (CN); ZHOU, Yuan, Shanghai, 201319 (CN)
(74) Representative: Elzaburu S.L.P.

(57) **Abstract**

A backlight assembly for a display unit includes a light source configured to emit a primary light, and at least one quantum dot rail configured to at least partially absorb the primary light and emit a secondary light. The at least one quantum dot rail includes a plurality of stabilized quantum dots embedded within a thermoplastic polymer matrix. Methods for making a backlight assembly include combining a plurality of stabilized quantum dots and a thermoplastic polymer matrix to form a mixture, extruding the mixture into at least one quantum dot rail, and incorporating the at least one quantum dot rail into the backlight assembly.

## Description

### FIELD OF THE DISCLOSURE

The present disclosure relates to a backlight assembly for a display unit, and in particular to a backlight assembly including at least one quantum dot rail including a plurality of stabilized quantum dots embedded within a thermoplastic polymer matrix.

### BACKGROUND OF THE DISCLOSURE

Quantum dots (QDs), which have tunable peak wavelength and a narrow emission spectral distribution, have attracted great attention from academic researchers and for their potential use in industry applications. A particular industry application of interest is in display applications. In one example, quantum dots are encapsulated in a glass tube as a rail-type structure that functions as an edge-lit backlight of a display. Unfortunately, the process for encapsulating QDs in the glass tube is complex, and the tube is subject to breakage during backlight unit assembly. As a result, the use of QDs in edge-lit backlight displays is limited; they are much more commonly used in QD enhanced film (QDEF) backlight applications.

These and other shortcomings are addressed by aspects of the disclosure.

### SUMMARY

Aspects of the disclosure relate to a backlight assembly for a display unit, including a light source configured to emit a primary light, and at least one quantum dot rail configured to at least partially absorb the primary light and emit a secondary light. The at least one quantum dot rail includes a plurality of stabilized quantum dots embedded within a thermoplastic polymer matrix.

Aspects of the disclosure further relate to methods for making a backlight assembly for a display. The backlight assembly includes a light source configured to emit a primary light and at least one quantum dot rail configured to at least partially absorb the primary light and emit a secondary light. The method includes: combining a plurality of stabilized quantum dots and a thermoplastic polymer matrix to form a mixture; extruding the mixture into at least one quantum dot rail; and incorporating the at least one quantum dot rail into the backlight assembly.

### BRIEF DESCRIPTION OF THE FIGURES

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 is a top perspective view of an exemplary backlight assembly according to aspects of the disclosure.
FIG. 2 is an emission spectrum of blue LED light used in the light simulation described in the examples.
FIG. 3 is an emission spectrum of green and red quantum dots used in the light simulation described in the examples.
FIG. 4 is a simulated emission spectrum of an exemplary backlight assembly according to aspects of the disclosure.

### DETAILED DESCRIPTION

The present disclosure can be understood more readily by reference to the following detailed description of the disclosure and the Examples included therein. In various aspects, the present disclosure relates to a backlight assembly for a display unit, including: a light source configured to emit a primary light; and at least one quantum dot rail configured to at least partially absorb the primary light and emit a secondary light. The at least one quantum dot rail includes a plurality of stabilized quantum dots embedded within a thermoplastic polymer matrix.

Before the present compounds, compositions, articles, systems, devices, and/or methods are disclosed and described, it is to be understood that they are not limited to specific synthetic methods unless otherwise specified, or to particular reagents unless otherwise specified, as such can, of course, vary. It is also to be understood that the terminology used herein is for the purpose of describing particular aspects only and is not intended to be limiting.

Various combinations of elements of this disclosure are encompassed by this disclosure, e.g., combinations of elements from dependent claims that depend upon the same independent claim.

Moreover, it is to be understood that unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is in no way intended that an order be inferred, in any respect. This holds for any possible non-express basis for interpretation, including: matters of logic with respect to arrangement of steps or operational flow; plain meaning derived from grammatical organization or punctuation; and the number or type of embodiments described in the specification.

All publications mentioned herein are incorporated herein by reference to disclose and describe the methods and/or materials in connection with which the publications are cited.

### Definitions

It is also to be understood that the terminology used herein is for the purpose of describing particular aspects only and is not intended to be limiting. As used in the specification and in the claims, the term "comprising" can include the embodiments "consisting of' and "consisting essentially of." Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

As used in the specification and the appended claims, the singular forms "a," "an" and "the" include plural referents unless the context clearly dictates otherwise. Thus, for example, reference to "a thermoplastic polymer" includes mixtures of two or more thermoplastic polymers.

As used herein, the term "combination" is inclusive of blends, mixtures, alloys, reaction products, and the like.

Ranges can be expressed herein as from one value (first value) to another value (second value). When such a range is expressed, the range includes in some aspects one or both of the first value and the second value. Similarly, when values are expressed as approximations, by use of the antecedent 'about,' it will be understood that the particular value forms another aspect. It will be further understood that the endpoints of each of the ranges are significant both in relation to the other endpoint, and independently of the other endpoint. It is also understood that there are a number of values disclosed herein, and that each value is also herein disclosed as "about" that particular value in addition to the value itself. For example, if the value "10" is disclosed, then "about 10" is also disclosed. It is also understood that each unit between two particular units are also disclosed. For example, if 10 and 15 are disclosed, then 11, 12, 13, and 14 are also disclosed.

As used herein, the terms "about" and "at or about" mean that the amount or value in question can be the designated value, approximately the designated value, or about the same as the designated value. It is generally understood, as used herein, that it is the nominal value indicated ±10% variation unless otherwise indicated or inferred. The term is intended to convey that similar values promote equivalent results or effects recited in the claims. That is, it is understood that amounts, sizes, formulations, parameters, and other quantities and characteristics are not and need not be exact, but can be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such. It is understood that where "about" is used before a quantitative value, the parameter also includes the specific quantitative value itself, unless specifically stated otherwise.

Disclosed are the components to be used to prepare the compositions of the disclosure as well as the compositions themselves to be used within the methods disclosed herein. These and other materials are disclosed herein, and it is understood that when combinations, subsets, interactions, groups, etc. of these materials are disclosed that while specific reference of each various individual and collective combinations and permutation of these compounds cannot be explicitly disclosed, each is specifically contemplated and described herein. For example, if a particular compound is disclosed and discussed and a number of modifications that can be made to a number of molecules including the compounds are discussed, specifically contemplated is each and every combination and permutation of the compound and the modifications that are possible unless specifically indicated to the contrary. Thus, if a class of molecules A, B, and C are disclosed as well as a class of molecules D, E, and F and an example of a combination molecule, A-D is disclosed, then even if each is not individually recited each is individually and collectively contemplated meaning combinations, A-E, A-F, B-D, B-E, B-F, C-D, C-E, and C-F are considered disclosed. Likewise, any subset or combination of these is also disclosed. Thus, for example, the sub-group of A-E, B-F, and C-E would be considered disclosed. This concept applies to all aspects of this application including, but not limited to, steps in methods of making and using the compositions of the disclosure. Thus, if there are a variety of additional steps that can be performed it is understood that each of these additional steps can be performed with any specific aspect or combination of aspects of the methods of the disclosure.

References in the specification and concluding claims to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

A weight percent of a component, unless specifically stated to the contrary, is based on the total weight of the formulation or composition in which the component is included.

As used herein, "polycarbonate" refers to an oligomer or polymer comprising residues of one or more dihydroxy compounds, e.g., dihydroxy aromatic compounds, joined by carbonate linkages; it also encompasses homopolycarbonates, copolycarbonates, and (co)polyester carbonates.

As used herein the terms "weight percent," "wt%," and "wt. %," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation are equal to 100.

Unless otherwise stated to the contrary herein, all test standards are the most recent standard in effect at the time of filing this application.

Each of the materials disclosed herein are either commercially available and/or the methods for the production thereof are known to those of skill in the art.

It is understood that the compositions disclosed herein have certain functions. Disclosed herein are certain structural requirements for performing the disclosed functions and it is understood that there are a variety of structures that can perform the same function that are related to the disclosed structures, and that these structures will typically achieve the same result.

### Backlight Assembly

Aspects of the disclosure relate to a backlight assembly for a display unit, including a light source configured to emit a primary light and at least one quantum dot rail configured to at least partially absorb the primary light and emit a secondary light. The at least one quantum dot rail includes a plurality of stabilized quantum dots embedded within a thermoplastic polymer matrix.

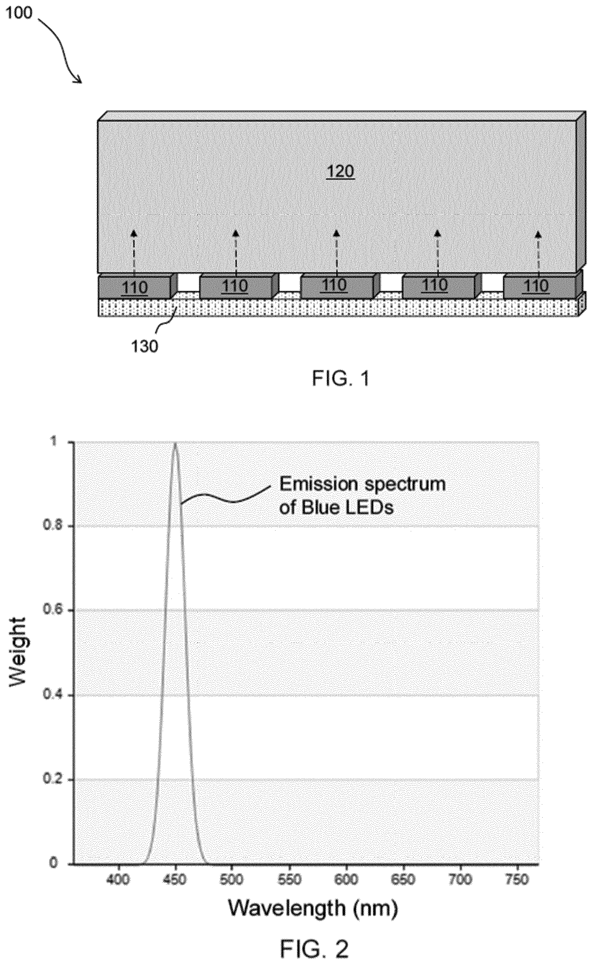

A purely exemplary backlight assembly 100 is illustrated in FIG. 1, and includes a plurality of quantum dot rails 110 including a plurality of stabilized quantum dots embedded within a thermoplastic polymer matrix. The plurality of quantum dot rails 110 are aligned along a side of a backlight unit 120. A light source 130 emits a primary light such as, but not limited to, blue LED or white light into the plurality of quantum dot rails 110, and each of the plurality of quantum dot rails 110 include stabilized quantum dots that emit light such as green or red light into the backlight unit 120. The plurality of quantum dot rails 110 at least partially absorb the primary light and emit a secondary light into the backlight unit 120. It will be recognized that other light configurations could be achieved by using a different primary light type and/or different types of quantum dots.

In some aspects the primary light is blue LED light or white light. In a particular aspect the primary light is blue LED light. The secondary light may be green light, red light or white light in some aspects.

Any thermoplastic material may be included in the thermoplastic polymer matrix of the quantum dot rail. In some aspects the quantum dot rail includes polymethylmethacrylate (PMMA), silicone, polycarbonate, copolymers thereof, blends thereof, or a combination thereof.

The thermoplastic matrix may be transparent in certain aspects. As used herein, "transparent" means that the thermoplastic polymer matrix has a light transmission of at least 85%, or in particular aspects at least 90%, when measured in accordance with ASTM D1003. In some aspects transmission is determined in accordance with ASTM D1003-00, Procedure A, using a Gardner-Haze plus instrument, a D65 illuminant and a 10-degree observer angle.

The at least one quantum rail may include a sufficient amount of stabilized quantum dots so as to achieve a desired light output. In some aspects the plurality of stabilized quantum dots are present in the thermoplastic polymer matrix in an amount of from about 0.1 wt% to about 1 wt%.

The plurality of stabilized quantum dots may be thermally, oxygen or moisture stable, and may be stabilized by any conventional process. In particular aspects the plurality of stabilized quantum dots are stabilized by applying a shell, such as but not limited to, a metal, silica or siloxane shell to the quantum dot.

In some aspects the plurality of stabilized quantum dots are concentration-gradient quantum dots. The plurality of stabilized quantum dots include a passivation layer in certain aspects. In further aspects the plurality of stabilized quantum dots include non-reactive surface ligands.

More specifically, in some aspects one or more of the plurality of stabilized quantum dots is a metal nanomaterial or an inorganic nanomaterial. The form of the plurality of stabilized quantum dots may include in certain aspects a nanoparticle, a nanofiber, a nanorod, or a nanowire.

Exemplary quantum dots according to aspects of the disclosure may include, but are not limited to, semiconductor nanocrystals selected from the group consisting of, but not limited to, Group II-VI semiconductor compounds, Group II-V semiconductor compounds, Group III-VI semiconductor compounds, Group III-V semiconductor compounds, Group IV-VI semiconductor compounds, Group II-III-VI compounds, Group II-IV-VI compounds, Group II-IV-V compounds, alloys thereof and combinations thereof.

Exemplary Group II elements include Zn, Cd, Hg or a combination thereof.

Exemplary Group III elements include Al, Ga, In, Ti or a combination thereof.

Exemplary Group IV elements include Si, Ge, Sn, Pb or a combination thereof.

Exemplary Group V elements include P, As, Sb, Bi or a combination thereof.

Exemplary Group VI elements include O, S, Se, Te or a combination thereof.

Exemplary Group II-VI semiconductor compounds include binary compounds, e.g., CdSe, CdS, CdTe, ZnS, ZnSe, ZnTe, ZnO, HgS, HgSe and HgTe; ternary compounds, e.g., CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS and HgZnSe; and quaternary compounds, e.g., CdZnSeS, CdZnSeTe, CdZnSTe, CdHgSeS, CdHgSeTe, CdHgSTe, HgZnSeS, HgZnSeTe and HgZnSTe.

Exemplary Group III-V semiconductor compounds include binary compounds, e.g., GaN, GaP, GaAs, GaSb, AlN, AlP, AlAs, AlSb, InN, InP, InAs and InSb; ternary compounds, e.g., GaNP, GaNAs, GaNSb, GaPAs, GaPSb, AlNP, AINAs, AINSb, AlPAs, AlPSb, InNP, InNAs, InN Sb, InPAs, InPSb, GaAlNP, AlGaN, AlGaP, AlGaAs, AlGaSb, InGaN, InGaP, InGaAs, InGaSb, AlInN, AlInP, AlInAs and AlInSb; and quaternary compounds, e.g., GaAlNAs, GaAlNSb, GaAlPAs, GaAlPSb, GaInNP, GaIn, NAs, GaInNSb, GaInPAs, GaInPSb, InAlNP, InAlNAs, InAlNSb, InAlPAs and InAlPSb.

Exemplary Group IV-VI semiconductor compounds include binary compounds, e.g., SnS, SnSe, SnTe, PbS, PbSe and PbTe; ternary compounds, e.g., SnSeS, SnSeTe, SnSTe, PbSeS, PbSeTe, PbSTe, SnPbS, SnPbSe and SnPbTe; and quaternary compounds, e.g., SnPbSSe, SnPbSeTe and SnPbSTe.

Exemplary Group IV semiconductor compounds include unary compounds, e.g., Si and Ge; and binary compounds, e.g., SiC and SiGe.

When used, a concentration-gradient quantum dot includes an alloy of at least two semiconductors. The concentration (molar ratio) of the first semiconductor gradually increases from the core of the quantum dot to the outer surface of the quantum dot, and the concentration (molar ratio) of the second semiconductor gradually decreases from the core of the quantum dot to the outer surface of the quantum dot. Exemplary concentration-gradient quantum dots are described in, e.g., U.S. Patent No. 7,981,667, the disclosure of which is incorporated herein by this reference in its entirety.

In one aspect, the concentration-gradient quantum dot includes two semiconductors, a first semiconductor having the formula

CdₓZn₁₋ₓS_{y}Se_{1-y}

and a maximum molar ratio at the core of the stabilized quantum dot that gradually decreases to a minimum molar ratio at the outer surface of the quantum dot and a second semiconductor having the formula

Zn_{z}Se_{1-z}S_{w}Se_{1-w}

and a maximum molar ratio at the outer surface of the stabilized quantum dot that gradually decreases to a minimum molar ratio at the core of the stabilized quantum dot.

In another aspect, the concentration-gradient quantum dot includes two semiconductors, a first semiconductor having the formula

CdZnₓS₁₋ₓ

and a maximum molar ratio at the core of the stabilized quantum dot that gradually decreases to a minimum molar ratio at the outer surface of the quantum dot and a second semiconductor having the formula

ZnCd_{z}S_{1-z}

and a maximum molar ratio at the outer surface of the stabilized quantum dot that gradually decreases to a minimum molar ratio at the core of the stabilized quantum dot.

Where the plurality of stabilized quantum dots are described herein as having a shell or a multi-shell structure (i.e., a core and at least one shell), the core and the shell or plurality of shells may independently be formed of the semiconductor materials described above. Examples of semiconductor shells include, but are not limited to, CdS, CdSe, CdTe, PbS, PbSe, PbTe, ZnS, ZnSe, ZnTe, CdZnS, CdZnSe, CdZnTe, CdZnTeSe, CdZnSSe, GaAs, GaP, GaN, InP, InAs, GaAlAs, GaAlP, GaAIN, GaInN, GaAlAsP, or GaAlInN.

If included, the passivation layer may include, but is not limited to, a metal oxide (e.g., Al₂O₃, MgO, ZnO, etc.). The metal oxide may be in the form as a shell material surrounding the quantum dot. The passivation layer may function to shield the quantum dot from harsh outer environmental conditions during the manufacturing process or during operation, and may help the quantum dot maintain its optical properties.

In certain aspects the plurality of stabilized quantum dots include non-reactive surface ligands. The non-reactive surface ligands may include any ligand type that will interact (e.g., attach) to the quantum dot. Exemplary non-reactive surface ligands include, but are not limited to, hydrophobic ligands such as trioctylphosphine/trioctylphosphine oxide (TOP/TOPO), long-chain alkyls, alkylamines, and alkylthiols etc. or hydrophilic ligands, such as thiolate alcohols, thiolate acids etc. or other types of tether functionalities or biofunctionalities for targeted applications. The non-reactive surface ligands protect the quantum dot from damage.

The plurality of stabilized quantum dots may have a size of from about 1 nanometer (nm) to about 100 nm in some aspects. In particular aspects the plurality of stabilized quantum dots have a size of from about 1 nm to about 50 nm, or from about 1 nm to about 30 nm.

The at least one quantum dot rail may be in any form suitable for use in the display. In some aspects the at least one quantum dot rail is in a form of a strip, a rod or a bar. The at least one quantum dot rail may have a polished or a textured surface; surface textures may be applied to modify the light profile of the secondary light as desired.

In particular aspects the at least one quantum dot rail does not include a barrier layer, such as but not limited to a glass tube or a polymer (e.g., polyethylene terephthalate (PET)) barrier layer. The use of stabilized quantum dots in the thermoplastic polymer matrix allows the at least one quantum dot rail to be formed without the use of a barrier layer, substantially simplifying the process for making the at least one quantum dot rail and eliminating the risk of breakage when, e.g., a glass tube is used.

### Methods for Making a Backlight Assembly

Aspects of the disclosure further relate to methods for making a backlight assembly for a display, the backlight assembly including a light source configured to emit a primary light and at least one quantum dot rail configured to at least partially absorb the primary light and emit a secondary light. The method includes: combining a plurality of stabilized quantum dots and a thermoplastic polymer matrix to form a mixture; extruding the mixture into at least one quantum dot rail; and incorporating the at least one quantum dot rail into the backlight assembly. The backlight assembly, including the light source and the at least one quantum dot rail, can include any of the components and have any of the properties described herein.

The use of stabilized quantum dots in the thermoplastic polymer matrix of the at least one quantum dot rail allows the at least one quantum dot rail to be formed in an extrusion process, in contrast to conventional quantum dot rails which must include a barrier layer. The method described herein eliminates the need for a barrier layer (e.g., glass or PET) to protect the at least one quantum dot rail and/or the quantum dots included therein.

Various combinations of elements of this disclosure are encompassed by this disclosure, e.g., combinations of elements from dependent claims that depend upon the same independent claim.

### Aspects of the Disclosure

In various aspects, the present disclosure pertains to and includes at least the following aspects.

Aspect 1. A backlight assembly for a display unit, comprising:
a light source configured to emit a primary light; and
at least one quantum dot rail configured to at least partially absorb the primary light and emit a secondary light,
wherein the at least one quantum dot rail comprises a plurality of stabilized quantum dots embedded within a thermoplastic polymer matrix.

Aspect 2. The backlight assembly according to Aspect 1, wherein the primary light is blue LED light.

Aspect 3. The backlight assembly according to Aspect 1 or 2, wherein the secondary light is green light, red light or white light.

Aspect 4. The backlight assembly according to any of Aspects 1 to 3, wherein the thermoplastic polymer matrix is transparent.

Aspect 5. The backlight assembly according to any of Aspects 1 to 4, wherein the thermoplastic polymer matrix comprises polymethylmethacrylate (PMMA), silicone, polycarbonate, copolymers thereof, blends thereof, or a combination thereof.

Aspect 6. The backlight assembly according to any of Aspects 1 to 5, wherein the plurality of stabilized quantum dots comprise from about 0.1 wt% to about 1 wt% of the at least one quantum dot rail.

Aspect 7. The backlight assembly according to any of Aspects 1 to 6, wherein the plurality of stabilized quantum dots comprise a metal, silica or siloxane shell.

Aspect 8. The backlight assembly according to any of Aspects 1 to 7, wherein the plurality of stabilized quantum dots are thermally, oxygen or moisture stable.

Aspect 9. The backlight assembly according to any of Aspects 1 to 8, wherein the at least one quantum dot rail is in a form of a strip, a rod or a bar.

Aspect 10. The backlight assembly according to any of Aspects 1 to 9, wherein the at least one quantum dot rail comprises a surface texture.

Aspect 11. The backlight assembly according to any of Aspects 1 to 10, wherein the at least one quantum dot rail does not include a barrier layer.

Aspect 12. The backlight assembly according to any of Aspects 1 to 11, wherein the at least one quantum dot rail is extruded.

Aspect 13. A method for making a backlight assembly for a display, the backlight assembly comprising a light source configured to emit a primary light and at least one quantum dot rail configured to at least partially absorb the primary light and emit a secondary light, the method comprising:
combining a plurality of stabilized quantum dots and a thermoplastic polymer matrix to form a mixture;
extruding the mixture into at least one quantum dot rail; and
incorporating the at least one quantum dot rail into the backlight assembly.

Aspect 14. The method according to Aspect 13, wherein the primary light is blue LED light.

Aspect 15. The method according to Aspect 13 or 14, wherein the secondary light is green light, red light or white light.

Aspect 16. The method according to any of Aspects 13 to 15, wherein the thermoplastic polymer matrix is transparent.

Aspect 17. The method according to any of Aspects 13 to 16, wherein the thermoplastic polymer matrix comprises polymethylmethacrylate (PMMA), silicone, polycarbonate, copolymers thereof, blends thereof, or a combination thereof.

Aspect 18. The method according to any of Aspects 13 to 17, wherein the plurality of stabilized quantum dots comprise from about 0.1 wt% to about 1 wt% of the at least one quantum dot rail.

Aspect 19. The method according to any of Aspects 13 to 18, wherein the plurality of stabilized quantum dots comprise a metal, silica or siloxane shell.

Aspect 20. The method according to any of Aspects 13 to 19, wherein the plurality of stabilized quantum dots are thermally, oxygen or moisture stable.

Aspect 21. The method according to any of Aspects 13 to 20, wherein the at least one quantum dot rail is in a form of a strip, a rod or a bar.

Aspect 22. The method according to any of Aspects 13 to 21, further comprising applying a surface texture to the at least one quantum dot rail.

Aspect 23. The method according to any of Aspects 13 to 22, wherein the at least one quantum dot rail does not include a barrier layer.

### EXAMPLES

The following examples are put forth so as to provide those of ordinary skill in the art with a complete disclosure and description of how the compounds, compositions, articles, devices and/or methods claimed herein are made and evaluated, and are intended to be purely exemplary and are not intended to limit the disclosure. Efforts have been made to ensure accuracy with respect to numbers (e.g., amounts, temperature, etc.), but some errors and deviations should be accounted for. Unless indicated otherwise, parts are parts by weight, temperature is in °C or is at ambient temperature, and pressure is at or near atmospheric. Unless indicated otherwise, percentages referring to composition are in terms of wt%.

There are numerous variations and combinations of reaction conditions, e.g., component concentrations, desired solvents, solvent mixtures, temperatures, pressures and other reaction ranges and conditions that can be used to optimize the product purity and yield obtained from the described process. Only reasonable and routine experimentation will be required to optimize such process conditions.

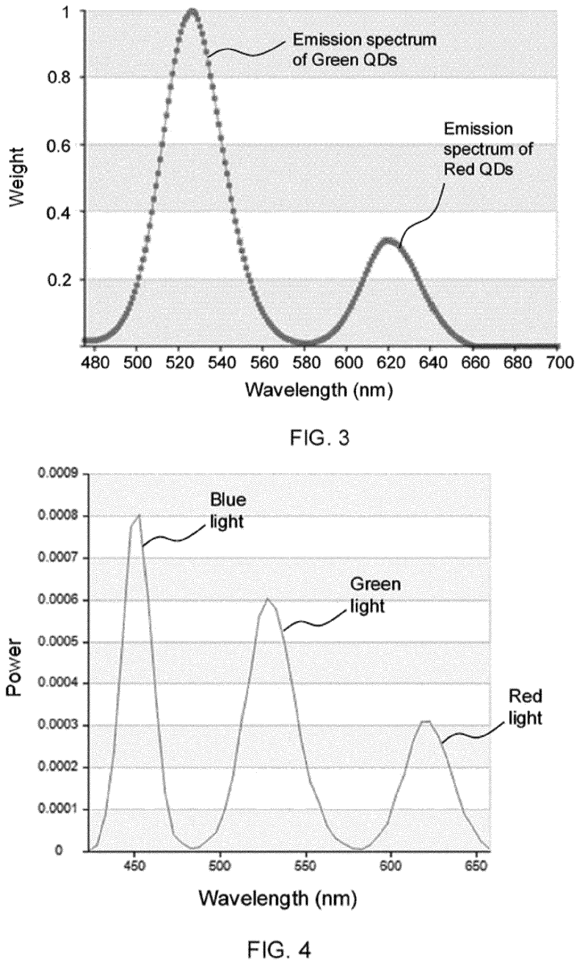

A light simulation of an exemplary backlight assembly including a plurality of quantum dot rails, each of the quantum dot rails including a plurality of stabilize quantum dots, was performed to demonstrate the feasibility of the application. With reference to FIG. 1, the backlight assembly 100 in the simulation included a plurality of quantum dot rails 110 including a plurality of stabilized quantum dots embedded within a PMMA matrix. A light source 130 emits blue LED light in accordance with the spectrum shown in FIG. 2. The plurality of quantum dot rails 110 include a plurality of stabilized green and red quantum dots having the emission spectrum shown in FIG. 3. The plurality of quantum dot rails emit a secondary light having the emission spectrum shown in FIG. 4. The relative peaks of blue, green and red light may be adjusted by adjusting the quantum dot loading in the plurality of quantum dot rails 110 to generate different types of light sources.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. § 1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A backlight assembly for a display unit, comprising:
a light source configured to emit a primary light; and
at least one quantum dot rail configured to at least partially absorb the primary light and emit a secondary light,
wherein the at least one quantum dot rail comprises a plurality of stabilized quantum dots embedded within a thermoplastic polymer matrix.

2. The backlight assembly according to claim 1, wherein the primary light is blue LED light.

3. The backlight assembly according to claim 1 or 2, wherein the secondary light is green light, red light or white light.

4. The backlight assembly according to any of claims 1 to 3, wherein the thermoplastic polymer matrix is transparent.

5. The backlight assembly according to any of claims 1 to 4, wherein the thermoplastic polymer matrix comprises polymethylmethacrylate (PMMA), silicone, polycarbonate, copolymers thereof, blends thereof, or a combination thereof.

6. The backlight assembly according to any of claims 1 to 5, wherein the plurality of stabilized quantum dots comprise from about 0.1 wt% to about 1 wt% of the at least one quantum dot rail.

7. The backlight assembly according to any of claims 1 to 6, wherein the plurality of stabilized quantum dots comprise a metal, silica or siloxane shell.

8. The backlight assembly according to any of claims 1 to 7, wherein the plurality of stabilized quantum dots are thermally, oxygen or moisture stable.

9. The backlight assembly according to any of claims 1 to 8, wherein the at least one quantum dot rail is in a form of a strip, a rod or a bar.

10. The backlight assembly according to any of claims 1 to 9, wherein the at least one quantum dot rail comprises a surface texture.

11. The backlight assembly according to any of claims 1 to 10, wherein the at least one quantum dot rail does not include a barrier layer.

12. The backlight assembly according to any of claims 1 to 11, wherein the at least one quantum dot rail is extruded.

13. A method for making a backlight assembly for a display, the backlight assembly comprising a light source configured to emit a primary light and at least one quantum dot rail configured to at least partially absorb the primary light and emit a secondary light, the method comprising:
combining a plurality of stabilized quantum dots and a thermoplastic polymer matrix to form a mixture;
extruding the mixture into at least one quantum dot rail; and
incorporating the at least one quantum dot rail into the backlight assembly.

14. The method according to claim 13, wherein the primary light is blue LED light.

15. The method according to claim 13 or 14, wherein the secondary light is green light, red light or white light.
